# EUROPEAN PATENT SPECIFICATION

(11) **EP 1 464 211 B1**
(45) Date of publication and mention of the grant of the patent: **22.03.2006**
(21) Application number: 02790654.4
(22) Date of filing: 06.12.2002
(51) Int. Cl.: H05K 3/00, H05K 13/00, H05K 1/14

(54) **ELECTRIC CIRCUIT MODULE AND METHOD FOR ITS ASSEMBLY**
ELEKTRONISCHER SCHALTUNGSMODUL UND VERFAHREN ZU DESSEN BESTÜCKUNG
MODULE DE CIRCUIT ELECTRONIQUE ET SON PROCEDE D'ASSEMBLAGE

(30) Priority: 06.12.2001 DE 10160041
(43) Date of publication of application: 06.10.2004
(73) Proprietor: Marconi Communications GmbH, 71500 Backnang (DE)
(72) Inventor: SCHMITT, Reinhold, 71546 Aspach (DE); KONRATH, Willibald, 71554 Cottenweiller (DE); SCHOLL, Klaus, 71522 Backnang (DE)
(74) Representative: Cockayne, Gillian
(86) International application number: PCT/IB2002/005720
(87) International publication number: WO 2003/049513

(56) References cited:
- EP-A- 0 654 821
- DE-A- 3 113 031
- DE-A- 19 511 486
- US-A- 5 044 615
- US-A- 5 210 941
- US-A- 5 488 256

## Description

The present invention relates to an electronic circuit module, in particular to a circuit module for generating and/or processing radio frequency signals, and a method for its assembly.

Conventionally, such circuit modules are assembled in automatic manufacturing lines using so-called boats, flat carrier plates whose external shape is adapted so as to allow for a steady and safe transport on a conveyor device of such an assembly line, and which are used to mount thereon a baseplate on which the circuit components of a finished circuit module will be fixed directly or indirectly.

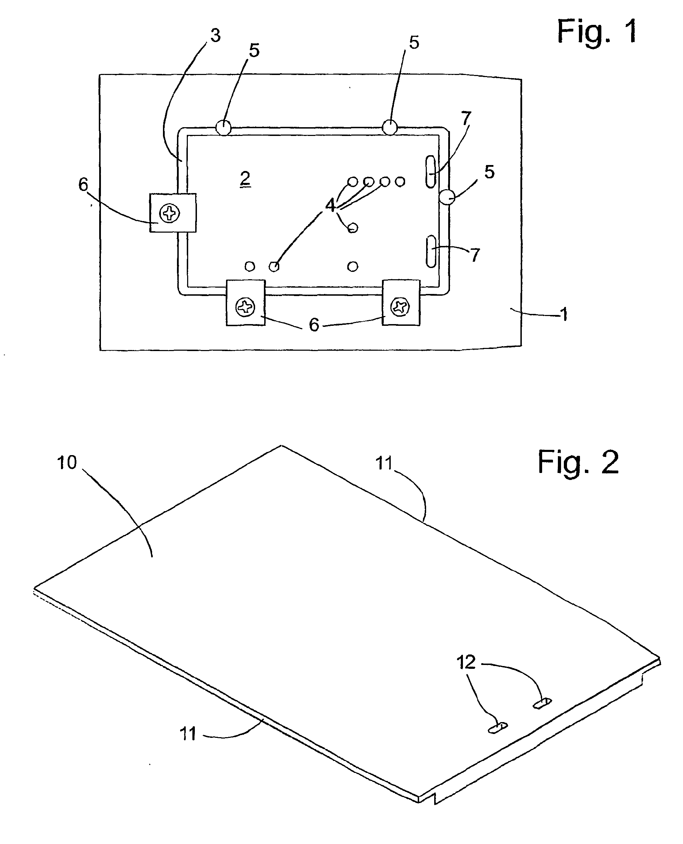

An example for such a conventional boat is shown in a plan view in Fig. 1. The space available on such a boat 1 for fixing a baseplate 2 (i.e. the area of the baseplate itself) is limited, so that when manufacturing RF hybrid circuits, in general, only circuit components which actually process a RF signal are arranged on the baseplate 2. Circuit components processing lower frequency signals, providing supply voltages for the RF hybrid circuit, etc., are usually located outside the baseplate 2. The baseplate 2 therefore requires a plurality of isolated feedthroughs 4 for voltage supply and/or signal exchange with a circuit board on which the baseplate will be mounted in a finished circuit module. These feed throughs are arranged in the baseplates 2 according to a pattern specific for an individual hybrid circuit.

Such a baseplate must be held absolutely tight and fixed on the boat 1, so that the individual circuit components may be placed on it and contacted with the required precision. For this purpose, the boat 1 conventionally has a machined cut-out 3 at its upper side, which is shaped so that the baseplate 2 may be placed in it with a clearance. At the edge of the cut-out 3, there is a plurality of metal pins 5 referred to as "mushrooms" inserted into the boat 1, which provide an exact abutment for positioning the baseplate 2. Further, at the edge of the cut-out 3, a plurality of gripping claws or blocks 5 is arranged, which, urged by a spring, press the baseplate 2 against boat 1 from above. Below each feed through 4 of the baseplate 2, the boat 1 must have a recess, which is able to receive a free end of a conductor held in feed through 4. Two windows 7 are provided for mounting hollow waveguides for feeding and/or carrying off RF signals.

Since the shape of the cut-out 3, the recesses formed therein and the location of the mushrooms 5 and of the blocks 6 is usually specific for each hybrid circuit to be manufactured, special boats must be produced for each manufacturing task. A high precision of the boats is required, since the bottom of the cut-out must have a very good flatness in order to prevent a baseplate held on it form tilting during the placing process, and the mushrooms must be positioned very exactly in order for an exact placement of circuit components on the baseplate to be possible.

Since for a predetermined manufacturing task, according to the size of the manufacturing line, several hundred boats must be provided, the costs of these contribute significantly to the total manufacturing costs.

In order to be able to test or balance circuits after assembly, it is necessary to separate them from the boat, since otherwise the signal and supply ports at the feed throughs 4 are not accessible. This increases the manufacturing effort additionally. Since the arrangement of the feed throughs 4 varies from one type of baseplate to another, either a type-specific tool is required for contacting the ports, or the required contact must be made individually for each feed through. The first possibility is expensive, the other is time-consuming.

DE 31 13 031A describes a method in which a module is placed on a carrier plate to be conveyed between various assembly stations.

The object of the present invention is to provide an electronic circuit module and a method for manufacturing such a circuit module, which allow for economic manufacture with high precision on an automatic manufacturing line independently from the size of a manufacturing batch.

The object is achieved on the one hand by a method, according to which a boat is placed on a conveyor means and is convered between various assembly stations of an assembly line for placing circuit components on the boat, fixing and/or contacting these, wherein the boat is used at the same time at a baseplate of the circuit module. I.e., instead of conventionally fixing a baseplate on a boat, mounting circuit components on the baseplate, and after mounting, separating the baseplate from the boat, the method according to the present invention requires no baseplate as an element separate or separable from the boat, since the same component, which during assembly fulfils the guiding and conveying functions of the boat will after assembly form the baseplate of the finished circuit module.

Although it might be expected that such a method might lead to increased costs, because each boat transits the manufacturing line only once and must then be replaced by a new one, careful reasoning shows that with the method according to the invention, considerable economies are to be achieved. The reason for this is that with the method of the invention, all cost-intensive steps of adapting a raw boat to a specific manufacturing task by machining, placing the mushrooms, etc. are no longer required. The material costs for the boat used as a baseplate according to the invention may be slightly higher than those of a conventional base-plate of increased size, but this is hardly important. A further potential for economies is achieved since according to the method and the circuit module of the present invention, cost intensive feed throughs can mostly be avoided.

The individual circuit components are preferably not mounted directly on the baseplate, but by one or more circuit substrates. In particular in case of radio frequency components, which must be placed with strict position tolerances, it is preferred to first fix the circuit substrate to the surface of the boat and then to place the circuit components on it. In case of circuit components having less strict requirements concerning the exactness of their placing, in particular concerning components for low working frequencies, it is also possible first to place the circuit components on the substrate and then to fix it as a unit on the boat.

Substrates of various types may be used, e.g. conventional printed circuit boards, in particular for a component having a low working frequency, or ceramic substrates, in particular for RF circuit components.

In order to make such a printed circuit board with components placed on it compatible with the cleanness requirements for a later mounting of RF components on the same boat, it is preferred to carry out a washing process of the circuit board with the circuit components mounted on it, either before mounting it on the boat or together with the boat.

The at least one substrate or the substrates preferably have a structure with internal conductor planes. These allow for signal connections to be placed on contact pads and to be contacted with other circuit members on the baseplate by wire bonding, instead of feeding them through the substrate and the baseplate. In this way, costs for the baseplates are saved, since expensive isolated feed throughs for the signals can be avoided; further, radio frequency and low frequency members of the circuit may be placed in close vicinity, whereby improvements in temporal behavior and signal quality of the circuit module can be achieved.

It is practical to arrange a substrate for RF components in a central region of the boat and a substrate for electronic components for low frequency operation in a peripheral region of the boat. In this way, a rather large surface is available on which the low frequency components may be placed at a small distance from the substrate bearing the radio frequency components, thus taking advantage of short signal paths.

A further advantage of this embodiment is related to the fact that among the electronic components for low frequency operation, there are frequently some that are taller than the radio frequency components. If by accident a substrate having the radio frequency substrate located centrally turns over during manufacture, in general only the tall components for low frequency operation will come into contact with a support; the radio frequency components, however, are protected from contact with the support and, hence, from damage.

Further features and advantages of the invention become apparent from the subsequent description of embodiments given with respect to the appended drawings.
Fig. 1, already discussed, shows a conventional boat for the automatic manufacture, which is equipped with a conventional baseplate;
Fig. 2 shows a baseplate adapted for carrying out a present invention;
Fig. 3 shows the baseplate of Fig. 2 with a printed circuit board having circuit components mounted on it;
Fig. 4 shows an enlarged view of a portion of the circuit board from Fig. 3 in a later phase of the method of the invention;
Fig. 5 shows a schematic cross section of the circuit module of the invention;
Fig. 6 shows a detailed view of a circuit module with a shielded RF circuit portion; and
Fig. 7 shows a view of a baseplate according to a second embodiment of the invention, in the same state of manufacture as in Fig. 3.

The invention is applicable in a conventional manufacturing line, not shown, having a conveyor means, in particular a band conveyor means, and a plurality of automatic devices arranged near the conveyor means such as placing, soldering or test devices, dispensing devices for adhesives or the like, etc..

The baseplate 10 shown in Fig. 2 is an aluminium plate having a thickness of a few mm and an essentially rectangular outline. Longitudinal edges 11 of the baseplate converge towards each other in an end portion facing the viewer, so that at this end portion, the baseplate 10 deviates from the ideal rectangular form by being slightly tapered. This outline of the base-plate 10 facilitates the transition between subsequent band conveyor means of an automatic manufacturing line, if these are not exactly aligned with respect to each other. Two bores 12 in the forward region of baseplate 10 are provided as ports for receiving RF waveguides. Apart from this, the upper side of the baseplate 10 is perfectly level. The external shape of the baseplate 10 and its dimensions are dictated by the requirements of the manufacturing system in which it is employed. According to the type of the manufacturing line, the baseplate may have a shape different from that shown as an example in Fig. 2. On the other hand, with a given manufacturing line, only a single type of baseplate 10 will be used, regardless of the kind of circuit module to be manufactured.

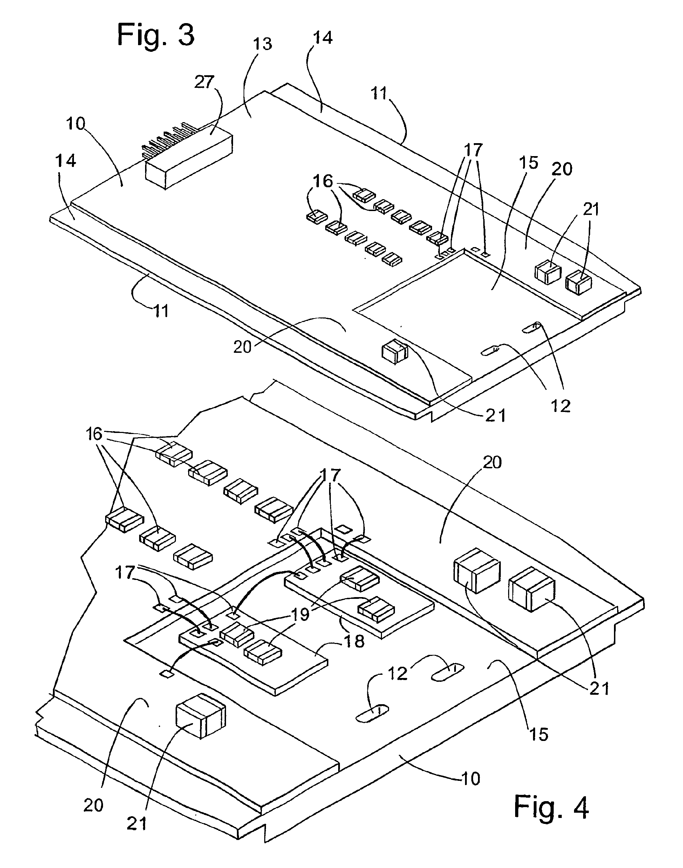

Fig. 3 shows the baseplate of Fig. 1 in an intermediate stage of the assembly method of the invention. A printed circuit board 13 is superficially fixed to the baseplate 10, e.g. by glueing. It covers the complete surface of the baseplate 10 except for narrow strips 14 at the longitudinal edges 11, which must remain free in order to be able to convey the baseplate 10 in the manufacturing line, and a peripheral cut-out 15 surrounding the bores 12. On the printed circuit board 13, electronic SMD components 16 and a connector 27 are placed and soldered.

The printed circuit board 13 has a multilayer structure, the bottom layer of which is a solid metal layer grounded by electric contact to the baseplate 10. On this metal layer, several layer pairs are placed, each of which is formed of an isolator layer and a structured conductor layer. The conductor layers are connected among each other and with the metal layer by vias (micro-vias) of the isolator layers, as required. Since such a structure is known as such, it need not be explained in further detail here.

At the edge of the cut-out 15, several gold-plated bond pads 17 are located and are connected to circuit components 16 of circuit board 13 by its structured conductors.

In order to assemble the circuit module according to the invention, the printed circuit board 13 may be provided together with the circuit components 16 placed and contacted thereon as a pre-assembled component, which need only be placed on baseplate 10 by a so-called pick-and-place machine. However, it is also possible first to place the printed circuit board 13 on the baseplate 10 without the components thereupon and then to equip it with the required components 16 and to solder these. In either case, it is practical to wash the circuit plate 13 before placing radio frequency components in the cut-out 15 thereof, in order to remove eventual residues from the soldering process or from other sources, which are incompatible with the cleanness requirements that have to be met when assembling radio frequency circuits.

Fig. 4 shows, in an enlarged perspective view, the front region of baseplate 10 having the cut-out 15 in a later stage of the assembly of the circuit module. In the cut-out 15, ceramic substrates 18, e.g. of alumina ceramics, are placed on which there are radio frequency circuit components 19. Like the circuit board 13, the ceramic substrates 18 have a continuous metalisation on the surface facing the baseplate 10, which is grounded by contact with the baseplate 10. A layer structure of the ceramic substrates 18 similar to the structure of the printed circuit board 13, with conductors embedded in the ceramic material, is conceivable, but is usually not required, because the number of components on the ceramic substrate 18 is usually smaller than that on the circuit board 13 and does not require conductors to cross each other on the substrate.

) Often, the necessity for crossings on the ceramic substrate 18 can be avoided by an appropriate lay-out of the conductors on the printed circuit board 13.

The figure shows two ceramic substrates 18, each bearing two circuit components 19, but it is obvious that ceramic substrates and radio frequency circuit components may be placed in any number required for the circuit module to be assembled.

When the circuit board 13 is placed on the base-plate 10 as a completely assembled, eventually cleaned component, the pick-and-place machine used therefore can in the same process step be used to place the ceramic substrates 18 and, on these, the RF circuit components 19. When the circuit board 13 is placed on the baseplate 10 without circuit components on it, and the circuit components 16 are arranged thereon afterwards, an assembly line may be preferred in which there is a first pick-and-place machine and a first soldering station for mounting the circuit board 13 and the circuit components 16, a washing station for cleaning the circuit board 13 together with the baseplate, and a second pick-and-place machine and a second soldering station for mounting the substrate 18 and the RF components 19.

After the ceramic substrates 18 have been placed on the baseplate 10 and the radio frequency circuit components 19 have been fixed to the ceramic substrates, the ceramic substrates 18 are contacted by wire bonding at bond pads 17 provided for this effect on both types of substrate 13 and 18, respectively. The circuit module thus assembled can now be tested immediately, without having to separate it from a support.

The test may simply be carried out by connecting a test connector of a testing bench to connector 27 and examining the reaction of the circuit module to predefined test signals. Since the connector 27 may be the same for many different types of circuit modules and may always be mounted at the same place of the baseplate 10, it is easy to automate the connection to the test connector and, thus, the execution of the test.

A testing bench for the circuit modules may even be completely integrated into the assembly line in that circuit components to be examined are automatically supplied to the testing bench and after examination are automatically conveyed further to stations in which balancing or defect repair steps are carried out that have been found necessary in the test.

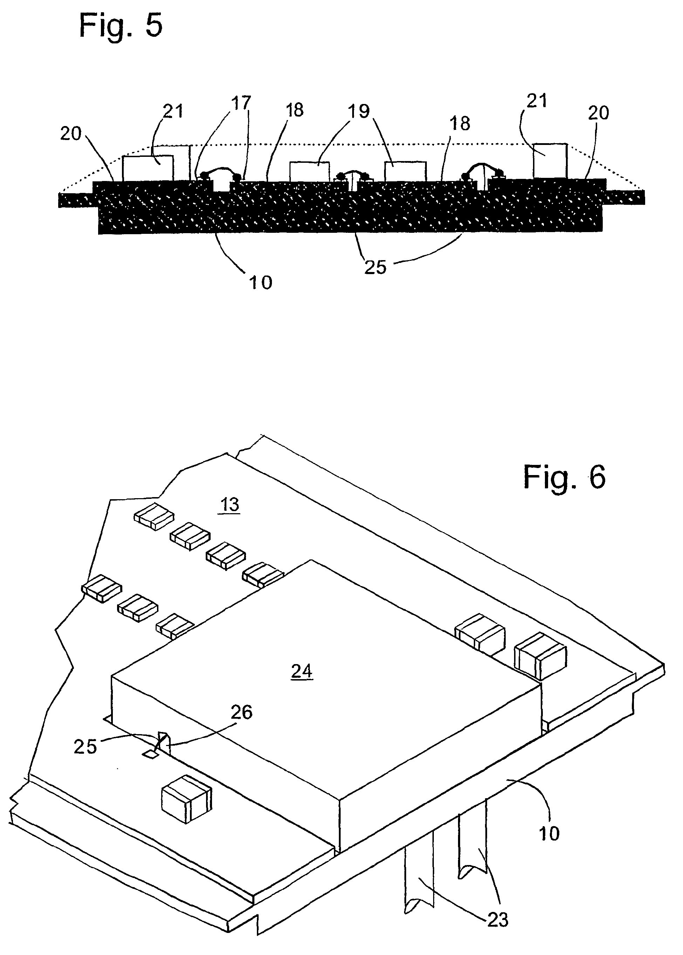

In the view of Fig. 4, particularly tall circuit components 21 are arranged on branches 20 of the printed circuit board 13 that extend along the sides of the cut-out 15. The purpose of this measure becomes apparent from the cross section of the circuit module shown in Fig. 5. If an assembly accident causes the circuit module to turn over and to hit a flat support, only the edges of the baseplate 10 and the outward corners of the circuit components 21 can come into contact with the support. All circuit components inside the dashed line 22 of Fig. 5, in particular the RF components 19, do not touch the support and can therefore not be damaged, bent or otherwise impaired.

At the end of the assembly process, after mounting RF waveguides 23 in the bores 12, a metallic cover 24 may be mounted over the ceramic substrates 18 carrying the RF circuit components 19, as shown in Fig. 6. In the embodiment shown here, the cover 24 has its side walls in direct electrical contact with the metal of baseplate 10, and for feeding through the bond wires 25 between the bond pads of circuit board 13 and the ceramic substrates, slots 26 are formed in the side walls of cover 24. A similar cover might instead be placed over the complete baseplate 10, so as to shield the low frequency circuit components 16, 21 from the environment, too.

The finished circuit module may now be mounted in a device, eventually together with other modules or circuit components.

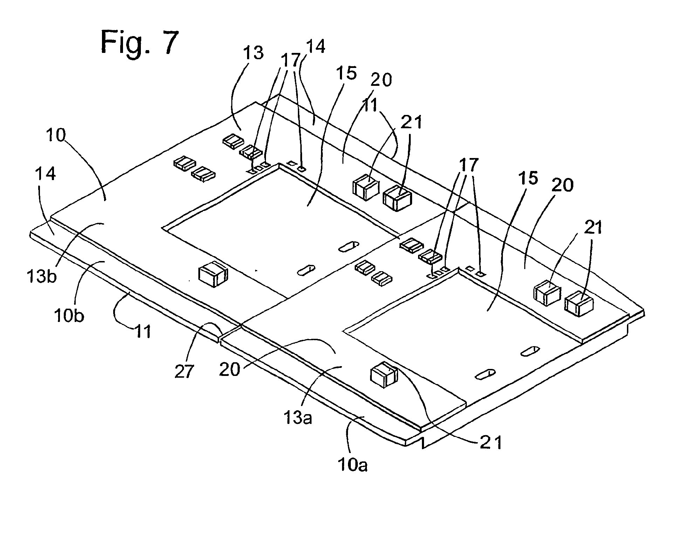

Evidently, there are applications where the complete surface of a boat is considerably larger than the surface which is required for all circuit components of the application. In such a case, it is useful to assemble several circuit modules simultaneously on the surface of one boat and to separate these from one another after the end of assembly. For this purpose, it is particularly appropriate to use a multi-part boat, as shown in Fig. 7 in a stage of the circuit assembly similar to that of Fig. 3. The boat 10 of Fig. 7 is made up of two parts, a front part 10a, which comprises the converging portions of the edges 11, and a rear part 10b, whose area is exactly rectangular here. In order to emphasize the two-part structure of the boat 10, a gap 27 is shown between the parts 10a, 10b in Fig. 7, but preferably, the two parts abut directly against each other. A solid connection between the two parts 10a, 10b is achieved by cementing thereon a one-part printed circuit board 13. The circuit board 13 is made up of two sections 13a, 13b covering the parts 10a, 10b, respectively, of the boat, and between which a breaking line is formed along gap 27, e.g. by a plurality of bores or by a scratch. On the two parts 10a, 10b of the boat, two identical circuit modules are built up during assembly, and after assembly, these are separated from one another simply by breaking along the breaking line, so that they can be built into different devices.

Of course, the boat may also be divided into three or more parts, and the division may extend not only transversely to the conveying direction, as shown here, but also parallel to it.

## Claims

1. A method for assembling: an electronic device having at least one circuit module comprising a baseplate (10) and circuit components (16, 19, 21) mounted on the baseplate, wherein a boal is placed on a conveyor means and is conveyed between various assembly stations in order to place, fix and/or contact the circuit components (16, 19, 21), **characterized in that** the boat is built into the electronic device as the baseplate (10).

2. A method according to claim 1, **characterised in that** at least one circuit substrate (13, 18) is fixed to a surface of the boat (10) and is then equipped with circuit components (16, 19, 21).

3. A method according to claim 1 or 2, **characterised in that** at least one circuit substrate (13) is first equipped with circuit components (16,19,21) and is then fixed to a surface of the boat (10).

4. A method according to one of the preceding claims, **characterized in that** as a first type of circuit substrate, a printed circuit board (13) is fixed to the boat (10).

5. A method according to one of the preceding claims, **characterized in that** as a second type of circuit substrate, a ceramic substrate (18) is fixed to the boat (10).

6. A method according to one of the preceding claims, **characterized in that** on a first circuit substrate (13) of the boat (10), electronic components (16, 21) for low frequency operation are soldered, that the first circuit substrate (13) is then cleaned, and that then radio frequency components (19) are mounted on a second circuit substrate (18) of the boat (10).

7. A method according to one of the preceding claims, **characterized in that** a substrate (13) for electronic components (16, 21) for low frequency operation and a substrate (18) for radio frequency components (9) are contacted by wire bonding.

8. A method according to one of the preceding claims, **characterized in that** a substrate (18) for radio frequency components is mounted in a central region (15) of the boat (10) and a substrate (13) for electronic components (16, 21) for low frequency operation is placed in a peripheral region (20) of the boat (10).

9. A method according to one of the preceding claims, **characterized in that** a test of the circuit module is carried out in a state mounted on the boat (10).

10. A method according to one of the preceding claims, **characterized in that** after assembly of the circuit components (16, 19, 21), a shielding cover (24) covering at least certain ones of the circuit components (19) is mounted on the boat (10).

11. A method according to one of the preceding claims, **characterized in that** a plurality of identical circuit modules is assembled using a single boat (10) as a common baseplate, and that afterwards the individual circuit modules are separated from each other.

12. A method according to claim 11, **characterized in that** a boat (10) formed of plural separate parts (10a, 10b) is used, and that on each part (10a, 10b) a circuit module is built up.

13. A method according to claim 12, **characterized in that** the parts (10a, 10b) for assembly of the circuit modules a re connected by a common circuit substrate (13).

14. An electronic circuit module having a plurality of circuit components (16, 19, 21) arranged on a baseplate, **characterized in that** the base-plate is designed as a boat (10) or part (10a, 10b) of a boat (10) for an automatic conveying and/or placing system.

15. An electronic circuit module according to claim 14, **characterized in that** the baseplate (10,10a, 10b) is rectangular and has two opposite edges (11) which, in the vicinity of one of their ends, converge towards each other when approaching said end.

16. An electronic circuit module according to claim 14 or 15, **characterized in that** the circuit components (16,19, 21) : are held on the base-plate (10, 10a, 10b) by at least one substrate (13, 18).

17. An electronic circuit module according to claim 16, **characterized in that** the substrate (13) has internal conductor planes.

18. An electronic circuit module according to claim 17, **characterized in that** the substrate (13, 18) has an external surface facing the base-plate (10, 10a, 10b) that has a grounded metalisation.

19. An electronic circuit module according to one of claims 14 to 18, **characterized in that** at least one substrate is a printed circuit board (13).

20. An electronic circuit module according to one of claims 14 to 19, **characterized in that** at least one substrate is a ceramic substrate (18).

21. An electronic circuit module according claim 20, **characterized in that** the ceramic substrate (18) is directly contacted to a printed circuit board (13) by bond wires (25).

22. An electronic circuit module according to one of claims 14 to 21, **characterized in that** a substrate (18) for radio frequency components (19) is arranged in the central region of the base-plate (10, 10a, 10b), and a substrate (13) for electronic components (16, 21) for low frequency operation is arranged in a peripheral region of the baseplate (10, 10a, 10b).

23. An electronic circuit module according to one of claims 14 to 22, **characterized in that** a substrate (18) for radio frequency components (19) is arranged in a cut-out (15) of a substrate (13) for electronic components (16, 21) for low frequency operation.

24. An electronic circuit module according claim 23, **characterized in that** the cut-out (15) is open-edged.

25. An electronic circuit module according to one of claims 14 to 24, **characterized in that** electronic components (21) for low frequency operation are arranged so as to prevent a contact between radio frequency components (19) and a support in any position of the circuit module.

## Patentansprüche

1. Verfahren zur Bestückung einer elektronischen Vorrichtung mit mindestens einem Schaltmodul, aufweisend eine Grundplatte,(10) und auf der Grundplatte befestigte Schaltungskomponenten (16, 19, 21), wobei ein Boot auf einem Fördermittel platziert ist und zwischen verschiedenen Bestückungsstationen befördert wird, um die Schaltungskomponenten (16, 19, 21) zu platzieren, zu fixieren und/oder in Kontakt zu bringen,
**dadurch gekennzeichnet,**
**daß** das Boot in die elektronische Vorrichtung als Grundplatte (10) eingebaut ist,

2. Verfahren gemäß Anspruch 1,
**dadurch gekennzeichnet,**
**daß** mindestens einer der Schaltungsträger (13, 18) auf einer Oberfläche des Bootes (10) fixiert und mit Schaltungskomponenten (16, 19, 21) ausgerüstet wird.

3. Verfahren gemäß Anspruch 1 oder 2,
**dadurch gekennzeichnet,**
**daß** mindestens einer der Schaltungsträger (13) zuerst mit Schaltungskomponenten (16, 19, 21) ausgerüstet und anschließend auf einer Oberfläche des Bootes (10) fixiert wird.

4. Verfahren gemäß einem der vorangegangenen Ansprüche,
**dadurch gekennzeichnet ,**
**daß** als ein erster Typ eines Schaltungsträgers ein gedruckter Schaltungsträger (13) an dem Boot fixiert wird.

5. Verfahren gemäß einem der vorangegangenen Ansprüche,
**dadurch gekennzeichnet ,**
**daß** als ein zweiter Typ eines Schaltungsträgers ein keramischer Träger (18) an dem Boot fixiert wird.

6. Verfahren gemäß einem der vorangegangenen Ansprüche,
**dadurch gekennzeichnet ,**
**daß** auf einem ersten Schaltungsträger (13) des Bootes elektronische Komponenten (16, 21) für Niedrigfrequenzbetrieb gelötet werden, daß der erste Schaltungsträger (13) danach gereinigt wird und dann Hochfrequenzkomponenten (19) auf einem zweiten Schaltungsträger (18) des Bootes befestigt werden.

7. Verfahren gemäß einem der vorangegangenen Ansprüche,
**dadurch gekennzeichnet,**
**daß** ein Träger (13) für elektronische Komponenten (16, 21) für Niedrigfrequenzbetrieb und ein Träger (18) für Hochfrequenzkomponenten (19) durch Drahtanschluß verbunden werden.

8. Verfahren gemäß einem der vorangegangenen Ansprüche,
**dadurch gekennzeichnet ,**
**daß** ein Träger (18) für Hochfrequenzkomponenten in einem zentralen Bereich (15) des Bootes (10) befestigt und ein Träger (13) für elektronische Komponenten (16, 21) für Niedrigfrequenzbetrieb in einem äußeren Bereich (20) des Boots (10) platziert wird.

9. Verfahren gemäß einem der vorangegangenen Ansprüche,
**dadurch gekennzeichnet ,**
**daß** ein Test des Schaltmoduls in einem auf dem Boot (10) befestigten Zustand durchgeführt wird.

10. Verfahren gemäß einem der vorangegangenen Ansprüche,
**dadurch gekennzeichnet,**
**daß** nach der Bestückung der Schaltungskomponenten (16, 19, 21) ein Abschirmdeckel (24) auf dem Boot befestigt wird, der zumindest bestimmte Schaltungskomponenten (19) abdeckt.

11. Verfahren gemäß einem der vorangegangenen Ansprüche,
**dadurch gekennzeichnet ,**
**daß** mehrere identische Schaltmodule unter Verwendung eines einzelnen Bootes (10) als gewöhnliche Grundplatte montiert werden und daß anschließend die einzelnen Schaltmodule voneinander getrennt werden.

12. Verfahren gemäß Anspruch 11,
**dadurch gekennzeichnet ,**
**daß** ein aus vielen Einzelteilen gebildetes Boot (10a, 10b) verwendet wird und daß auf jedem Teil (10a, 10b) ein Schaltmodul aufgebaut wird.

13. Verfahren gemäß Anspruch 12,
**dadurch gekennzeichnet ,**
**daß** die Teile (10a, 10b) zur Bestückung der Schaltmodule über einen gewöhnlichen Schaltungsträger (13) verbunden werden.

14. Elektronisches Schaltmodul mit mehreren auf einer Grundplatte angeordneten Schaltungskomponenten (16, 19, 21),
**dadurch gekennzeichnet,**
**daß** die Grundplatte als Boot (10) oder als Teil (10a, 10b) eines Bootes (10) für ein automatisches Förder- und/oder Platzierungssystem ausgebildet ist.

15. Elektronisches Schaltmodul gemäß Anspruch 14,
**dadurch gekennzeichnet,**
**daß** die Grundplatte (10, 10a, 10b) rechteckig ist und zwei gegenüberliegende Kanten (11) aufweist, die in der Nähe eines ihrer Enden zueinander laufen, wenn sie dieses Ende erreichen.

16. Elektronisches Schaltmodul gemäß Anspruch 14 oder 15,
**dadurch gekennzeichnet,**
**daß** die Schaltungskomponenten (16, 19, 21) auf der Grundplatte (10, 10a, 10b) von mindestens einem Träger (13, 18) gehalten werden.

17. Elektronisches Schaltmodul gemäß Anspruch 16,
**dadurch gekennzeichnet ,**
**daß** der Träger (13) interne Leiterflächen aufweist.

18. Elektronisches Schaltmodul gemäß Anspruch 17,
**dadurch gekennzeichnet ,**
**daß** der Träger (13, 18) eine äußere, der Grundplatte (10, 10a, 10b) zugewandte Oberfläche hat, die eine geerdete Metallbeschichtung aufweist.

19. Elektronisches Schaltmodul gemäß einem der Ansprüche 14 bis 18,
**dadurch gekennzeichnet ,**
**daß** mindestens ein Träger ein gedruckter Schaltungsträger (13) ist.

20. Elektronisches Schaltmodul gemäß einem der Ansprüche 14 bis 19,
**dadurch gekennzeichnet,**
**daß** mindestens ein Träger ein keramischer Träger (18) ist.

21. Elektronisches Schaltmodul gemäß Anspruch 20,
**dadurch gekennzeichnet ,**
**daß** der keramischer Träger (18) direkt mit einem gedruckten Schaltungsträger (13) über Kabel (25) verbunden ist.

22. Elektronisches Schaltmodul gemäß einem der Ansprüche 14 bis 21,
**dadurch gekennzeichnet,**
**daß** ein Träger (18) für Hochfrequenzkomponenten (19) in einem zentralen Bereich (15) des Bootes (10, 10a, 10b) und ein Träger (13) für elektronische Komponenten (16, 21) für Niedrigfrequenzbetrieb in einem äußeren Bereich (20) des Boots (10, 10a, 10b) angeordnet ist.

23. Elektronisches Schaltmodul gemäß einem der Ansprüche 14 bis 22,
**dadurch gekennzeichnet ,**
**daß** ein Träger (18) für Hochfrequenzkomponenten (19) in einem Ausschnitt (15) eines Trägers (13) für elektronische Komponenten (16, 21) für Niedrigfrequenzbetrieb angeordnet ist.

24. Elektronisches Schaltmodul gemäß Anspruch 23,
**dadurch gekennzeichnet,**
**daß** der Ausschnitt (15) offenkantig ist.

25. Elektronisches Schaltmodul gemäß einem der Ansprüche 14 bis 24,
**dadurch gekennzeichnet,**
**daß** die elektronischen Komponenten (16, 21) für Niedrigfrequenzbetrieb derart angeordnet sind, daß sie einen Kontakt zwischen Hochfrequenzkomponenten (19) und einer Halterung in jeder Position des Schaltmoduls vermeiden.

## Revendications

1. Procédé d'assemblage d'un dispositif électronique ayant au moins un module de circuit comprenant une plaque de base (10) et des composants de circuit (16, 19, 21) montés sur la plaque de base, dans lequel une nacelle est placée sur des moyens formant transporteur et est transportée entre diverses stations d'assemblage afin de placer, fixer et/ou mettre en contact les composants de circuit (16, 19, 21), **caractérisé en ce que** la nacelle est intégrée dans le dispositif électronique au titre de la plaque de base (10).

2. Procédé selon la revendication 1, **caractérisé en ce qu'**au moins un substrat de circuit (13, 18) est fixé à une surface de la nacelle (10) et est ensuite équipé de composants de circuit (16, 19, 21).

3. Procédé selon la revendication 1 ou 2, **caractérisé en ce qu'**au moins un substrat de circuit (13) est d'abord équipé de composants de circuit (16, 19, 21) et est ensuite fixé à une surface de la nacelle (10).

4. Procédé selon une des précédentes revendications, **caractérisé en ce que**, en tant que un premier type de substrat de circuit, une carte à circuit imprimé (13) est fixée à la nacelle (10).

5. Procédé selon une des précédentes revendications, **caractérisé en ce que**, en tant que second type de substrat de circuit, un substrat en céramique (18) est fixé à la nacelle (10).

6. Procédé selon une des précédentes revendications, **caractérisé en ce que** des composants électroniques (16, 21) dédiés à un fonctionnement à basses fréquences sont brasés sur un premier substrat de circuit (13) de la nacelle (10), **en ce que** le premier substrat de circuit (13) est ensuite nettoyé et **en ce que** des composants à radiofréquences (19) sont par après montés sur un second substrat de circuit (18) de la nacelle (10).

7. Procédé selon une des précédentes revendications, **caractérisé en ce qu'**un substrat (13) destiné à des composants électroniques (16, 21) dédiés à un fonctionnement à basses fréquences et un substrat (18) destiné à des composants à radiofréquences (19) sont mis en contact par des microcâblages.

8. Procédé selon une des précédentes revendications, **caractérisé en ce qu'**un substrat (18) destiné à des composants à radiofréquences est monté dans une région centrale (15) de la nacelle (10) et un substrat (13) destiné à des composants électroniques (16, 21) dédiés à un fonctionnement à basses fréquences est placé dans une région périphérique (20) de la nacelle (10).

9. Procédé selon une des précédentes revendications, **caractérisé en ce qu'**un essai du module de circuit est réalisé quand il est dans un état monté sur la nacelle (10).

10. Procédé selon une des précédentes revendications, **caractérisé en ce que**, après l'assemblage des composants de circuit (16, 19, 21), une couverture de blindage (24) couvrant au moins certains des composants de circuit (19) est montée sur la nacelle (10).

11. Procédé selon une des précédentes revendications, **caractérisé en ce qu'**une pluralité de modules de circuit identiques sont assemblés en utilisant une seule nacelle (10) à titre de plaque de base commune et **en ce que**, par la suite, les modules de circuit individuels sont séparés les uns des autres.

12. Procédé selon la revendication 11, **caractérisé en ce qu'**il utilise une nacelle (10) constituée de plusieurs parties séparées (10a, 10b) et **en ce qu'**un module de circuit est élaboré sur chaque partie (10a, 10b).

13. Procédé selon la revendication 12, **caractérisé en ce que** les parties (10a, 10b) permettant un assemblage des modules de circuit sont reliées par un substrat de circuit commun (13).

14. Module de circuit électronique ayant une pluralité de composants de circuit (16, 19, 21) agencés sur une plaque de base, **caractérisé en ce que** la plaque de base est conçue comme une nacelle (10) ou une partie (10a, 10b) d'une nacelle (10) adaptée pour un système de transport et/ou de placement automatique.

15. Module de circuit électronique selon la revendication 14, **caractérisé en ce que** la plaque de base (10, 10a, 10b) est rectangulaire et a deux bords opposés (11) qui, au voisinage d'une de leurs extrémités, convergent l'un vers l'autre lorsqu'ils se rapprochent de ladite extrémité.

16. Module de circuit électronique selon la revendication 14 ou 15, **caractérisé en ce que** les composants de circuit (16, 19, 21) sont maintenus sur la plaque de base (10, 10a, 10b) par au moins un substrat (13, 18).

17. Module de circuit électronique selon la revendication 16, **caractérisé en ce que** le substrat (13) possède des plans conducteurs internes.

18. Module de circuit électronique selon la revendication 17, **caractérisé en ce que** le substrat (13, 18) a une surface externe faisant face à la plaque de base (10, 10a, 10b) qui présente une métallisation mise à la masse.

19. Module de circuit électronique selon une des revendications 14 à 18, **caractérisé en ce qu'**au moins un substrat est une carte à circuit imprimé (13).

20. Module de circuit électronique selon une des revendications 14 à 19, **caractérisé en ce qu'**au moins un substrat est un substrat en céramique (18).

21. Module de circuit électronique selon la revendication 20, **caractérisé en ce que** le substrat en céramique (18) est mis directement en contact avec une carte à circuit imprimé (13) par l'intermédiaire de microcâblages (25).

22. Module de circuit électronique selon une des revendications 14 à 21, **caractérisé en ce qu'**un substrat (18) destiné à des composants à radiofréquences (19) est agencé dans la région centrale de la plaque de base (10, 10a, 10b) et un substrat (13) destiné à des composants électroniques (16, 21) dédiés à un fonctionnement à basses fréquences est agencé dans une région périphérique de la plaque de base (10, 10a, 10b).

23. Module de circuit électronique selon une des revendications 14 à 22, **caractérisé en ce qu'**un substrat (18) destiné à des composants à radiofréquences (19) est agencé dans un évidement (15) d'un substrat (13) destiné à des composants électroniques (16, 21) dédiés à un fonctionnement à basses fréquences.

24. Module de circuit électronique selon la revendication 23, **caractérisé en ce que** l'évidement (15) est à bords ouverts.

25. Module de circuit électronique selon une des revendications 14 à 24, **caractérisé en ce que** des composants électroniques (21) dédiés à un fonctionnement à basses fréquences sont agencés de façon à empêcher un contact entre des composants à radiofréquences (19) et un support dans une quelconque position du module de circuit.
